# EUROPÄISCHE PATENTSCHRIFT

(11) **EP 1 776 006 B1**
(45) Veröffentlichungstag und Bekanntmachung des Hinweises auf die Patenterteilung: **24.08.2011**
(21) Anmeldenummer: 06021447.5
(22) Anmeldetag: 12.10.2006
(51) Int. Cl.: H05K 9/00, B29B 17/00, H01B 1/22, B29B 7/88

(54) **Elektrisch leitfähiges Kunststoff-Formteil aus recyceltem Reject-Material**
Electrically conductive plastic material from recycled reject material
Materiau plastique electro-conducteur fabriqué à partir d'un matériau recyclé rejeté

(30) Priorität: 13.10.2005 DE 102005048976
(43) Veröffentlichungstag der Anmeldung: 18.04.2007
(73) Patentinhaber: Messing, Manfred, 72800 Eningen u. A. (DE)
(72) Erfinder: Messing, Manfred, 72800 Eningen u. A. (DE)

(56) Entgegenhaltungen:
- EP-A- 0 634 258
- WO-A-00/78127
- WO-A-2005/083721
- WO-A1-01/72100
- DE-U1- 9 207 044
- US-A- 4 156 751
- US-A- 5 613 610
- US-A- 5 811 050
- US-A1- 2004 075 193
- US-A1- 2004 120 131

## Beschreibung

Die Erfindung betrifft ein Verfahren zur Herstellung eines spritzgegossenen kunststoff-Formteils ,insbesondere Behälter, mit elektrischem Widerstand R < 10⁸ Ω, insbesondere R ≤ 10⁴Ω, sowie mit Abschirmwirkung gegen elektromagnetische Strahlung. Ferner betrifft die Erfindung ein durch dieses Verfahren hergestellte Formteil.

Derartige Kunststoff-Formteile sind weltweit seit vielen Jahrzehnten allgemein im Gebrauch. Ein besonders wichtiges Anwendungsfeld für solche Teile ist die Herstellung von leitfähigen Behältern zur Aufbewahrung und zum Transport von empfindlichen Elektronik-Komponenten, die vor Beschädigungen aufgrund elektrostatischer Aufladungen der Behälterwände oder durch die Einwirkung elektromagnetischer Felder geschützt werden sollen. Spezialbehälter dieser Art sind beispielsweise in der Firmendruckschrift "ESD-Systemlösungen" der Firma Keinath Electronic, 72810 Gomaringen/DE, Seiten 68/69 aus dem Jahr 2002 oder im Katalog der Firma BJZ Industriedienst und Vertrieb, 75031 Eppingen/DE, Seiten 118/119 aus dem Jahr 2005 beschrieben.

Für den sicheren Versand von ESD-Bauteilen oder zur geschützten Lagerung von SMD-Bauteilen werden Boxen und Behälter verschiedenster Formen und Größen angeboten, die aus elektrisch leitfähigem Polyethylen, Polypropylen oder Polystyrol mit hohen Anteilen von Kohlenstoff aufgebaut sind, welche für eine ausreichend hohe elektrische Leitfähigkeit der Formteile sorgen, so dass typische Oberflächenwiderstände in der Größenordnung 10⁴Ω bis 10⁶Ω erreicht werden.

Nachteilig bei diesen Lösungen sind jedoch eben die genannten hohen Kohlenstoffanteile, die zwar einerseits die elektrische Leitfähigkeit und damit die Schutzfunktion des Materials sicherstellen, andererseits aber zu einer generellen Schwarzfärbung sowie zu einem schwarzen, leitfähigen Abrieb von den Behälteroberflächen bei normaler Benutzung führen. Außerdem wird durch die Zugabe von großen Mengen Kohlenstoff ein wertvoller und kostenintensiver Rohstoff verbraucht.

Die US 2004/0120131 A1 offenbart einen ther moformbaren Polymerfilm mit einer elektromagnetischen Abschirmwirkung. Ein weiterer Polymerfilm mit antistatischen Eigenschaften ist in der US 4,156,751 beschrieben.

Aufgabe der vorliegenden Erfindung ist es demgegenüber, mit möglichst einfachen technischen Mitteln ein Kunststoff-Formteil der eingangs beschriebenen Art dahingehend weiter zu entwickeln, dass auch ohne den Einsatz von hohen Kohlenstoffanteilen im Material eine ausreichend hohe elektrische Leitfähigkeit und Abschirmwirkung beim erzeugten Formteil erzielt wird, um eine Beschädigung von eingelegten empfindlichen Elektronik-Komponenten sicher zu verhindern, wobei die Materialkosten möglichst gering gehalten und eine umweltfreundliche Materialauswahl getroffen werden sollen.

Erfindungsgemäß wird diese Aufgabe auf ebenso überraschend einfache wie wirkungsvolle Art und Weise durch ein Verfahren nach Anspruch 1 gelöst, wobei das hergestellte Formteil mindestens zur Hälfte aus recyceltem Reject-Material bestehend aus Polyäthylen mit einem Gewichts-Anteil von mindestens 10% Aluminium aufgebaut ist.

Durch die erfindungsgemäße Lösung wird aufgrund des relativ hohen, im Reject-Material ohnehin vorhandenen Metallanteils, nicht nur annähernd ausreichend hohe elektrische Leitfähigkeit und Abschirmwirkung beim erzeugten Formteil sichergestellt, sondern durch die Rohstoff schonende Möglichkeit der Einsparung von hohen Kohlenstoffanteilen kann auch der Verbrauch von wertvollem Rohstoff gering gehalten, der Rußabrieb von der Oberfläche des Formteils minimiert und eine von der Schwarzfärbung abweichende Farbgestaltung erreicht werden.

Besonders bevorzugt ist eine Ausführungsform der Erfindung, bei der der Aluminium-Anteil im Reject-Material ca. 15 bis 20 Gew% beträgt. Dies entspricht den bei üblichem und in relativ großen Mengen ständig anfallendem Reject-Material aus der DSD-Getränkekarton-Verwertung vorherrschenden Verhältnissen, so dass hierdurch hochwertiger aluminiumhaltiger Abfallstoff einer sinnvollen Wiederverwertung zugeführt wird, wobei auf sehr preisgünstige Weise die für die elektrische Leitfähigkeit und Abschirmwirkung des Formteil-Materials erforderlichen geringen elektrischen Oberflächenwiderstände erreicht werden.

Bei einer großtechnisch besonders leicht zu realisierenden Ausführungsform der Erfindung liegt das recycelte Reject-Material vor der Herstellung des Formteils durch Spritzgießen in geschredderter und granulierter Form vor, so dass es ohne zusätzliche Fertigungsschritte üblichen Kunststoff-Verarbeitungsmaschinen zugeführt werden kann.

Eine preisgünstige Erhöhung der elektrischen Leitfähigkeit und Abschirmwirkung des Formteil-Materials lässt sich mit Ausführungsformen der Erfindung erzielen, bei denen das Formteil Kohlefasern zwischen 0,1 und 15 Gew% bei Einsatz von gemahlenen Kohlefasern, 0,1 - 12 Gew% bei Einsatz von Kohlefasern als Stapelfasern und 0,1 - 6 Gew% bei Einsatz von Kohlefaserroving enthält, In diesem Konzentrationsbereich führt die Kohlenstoff-Beigabe auch zu einem erträglich geringen Abrieb von der Material-Oberfläche.

Eine vorteilhafte Weiterbildung dieser Ausführungsform sieht vor, dass die Kohlefasern bei der Herstellung des Formteils durch Spritzgießen ausgehend von Rovings zudosiert werden. Dadurch muss keine Compoundierung der Kohlefasern mit dem Reject-Material vor der Herstellung des Formteils erfolgen, sondern eine simultane Verarbeitung beider Materialien ohne einen vorbereitenden Arbeitsschritt wird ermöglicht.

Ganz besonders vorteilhaft sind allerdings Ausführungsformen der Erfindung, bei denen das Formteil weniger als 1 Gew% elementaren Kohlenstoff in Form von Kohle, Ruß oder Graphit enthält, vorzugsweise vollständig frei von Kohlenstoff ist. Hierdurch kann dann auch mit Sicherheit ein schwarzer Kohlenstoffabrieb von im Laufe der Zeit an die Oberfläche des Formteils migrierenden Kohlepartikeln verhindert werden.

Besonders preiswert und umweltfreundlich sind Ausführungsformen der Erfindung, bei denen das Formteil vollständig aus recyceltem Reject-Material aufgebaut ist.

Alternativ kann das Formteil aber auch neben dem recycelten Reject-Material ein oder mehrere Additive enthalten, insbesondere fein verteiltes Material mit einer höheren elektrischen Leitfähigkeit als der des Reject-Materials. Dadurch werden ganz gezielte Variationen der physikalischen Eigenschaften und Parameter des Endmaterials für das erfindungsgemäße Formteil ermöglicht.

Bei einer besonders bevorzugten Weiterbildung dieser Ausführungsformen sind die Menge und/oder die elektrischen Eigenschaften des Additivs so gewählt, dass das Formteil einen elektrischen Widerstand R zwischen 10² 0hm und 10⁸ Ohm, vorzugsweise zwischen 10⁴ Ohm und 10⁷ Ohm aufweist. Übliche von der Industrie geforderte Ableitwerte für aufladungsfreie Behältnisse liegen nämlich in diesen Größenbereichen.

Eine weitere Erhöhung der elektrischen Leitfähigkeit und Abschirmwirkung des Formteil-Materials lässt sich auf fertigungstechnisch einfache Weise mit Weiterbildungen dieser Ausführungsformen erzielen, bei denen das Additiv Metallpartikel umfasst.

Besonders preiswert, Ressourcen schonend und umweltfreundlich sind Weiterbildungen, bei denen das Additiv recyceltes Abfall-Material enthält, insbesondere Kunststoffmaterial mit metallhaltigen Partikeln.

Vorzugsweise umfasst das Additiv Polystyrolmaterial mit Metallpartikeln, insbesondere mit Aluminium, wie es ständig in großen Mengen als Stanzgitterfolien-Abfall anfällt, etwa bei der Herstellung von Milch-Portionsbechern, Jogurtbechern etc., die tiefgezogenes, mit Aluminiumfolie kaschiertes Polystyrol aufweisen.

Eine besonders hohe elektrische Leitfähigkeit des erfindungsgemäßen Formteils lässt sich bei Weiterbildungen erzielen, bei denen das Additiv anstelle von Metallkörnern oder Pulvern längliche und/oder flächige Schnitzel, Streifen oder Fäden aus Metallfolie, insbesondere Aluminiumfolie oder Weicheisenfolie enthält.

Ganz besonders bevorzugt weist die Metallfolie eine Dicke zwischen 5 µm und 50 µm, insbesondere zwischen 15 µm und 25 µm, auf, was im typischen Größenbereich von üblichen Folienabfällen liegt.

Bei einer Klasse von vorteilhaften Weiterbildungen kann das Additiv einen Haftvermittler aufweisen, der die Stabilität und Festigkeit des erfindungsgemäßen Formteils ganz erheblich erhöht. Auch kann hierdurch das Reject-Material mit anderen Materialien verbunden werden, die sonst keine feste mechanische Verbindung mit dem Reject-Material eingehen würden, so dass die Materialauswahl für das Formteil im Hinblick auf speziell gewünschte Eigenschaften enorm vergrößert wird.

Weiterhin kann das Additiv alternativ oder zusätzlich auch Farbpigmente aufweisen, die eine bunte und farblich differenzierte Gestaltung des Erfindungsgemäßen Formteils gestatten. Insbesondere wird damit eine einfache optische Markierung von Lager- und Transportbehältern für empfindliche elektronische Komponenten ermöglicht, etwa ein so genanntes "Ampelsystem", bei welchem rote Behälter für Ausschussteile, gelbe (oder blaue) Behälter für Nacharbeitsteile und grüne Behälter für qualitativ hochwertige Teile vorgesehen sind.

Typische Formen der erfindungsgemäßen Formteile können Kästen und Wannen sein, insbesondere zum Einsatz als Behälter zur Aufbewahrung von empfindlichen Elektronikbauteilen.

Für die Anwendung bei Leitungen, Kabelkanälen etc. können die erfindungsgemäßen Formteile aber auch röhrenförmig, rinnenförmig oder trogförmig gestaltet sein.

Bei weiteren Ausführungsformen können die erfindungsgemäßen Formteile auch Elemente der Innenarchitektur, insbesondere Deckenverkleidungs-, Wandverkleidungs- oder Bodenbedeckungs-Elemente sowie Dachziegel und andere Dachabdeckungen sein und zum Zwecke der Abschirmung gegen elektromagnetische Strahlungen ("Elektrosmog") eingesetzt werden.

Eine weitere besonders bevorzugte Ausführungsform der Erfindung zeichnet sich dadurch aus, dass das Reject-Material nicht nur im Inneren des Formteils vorhanden ist, sondern zumindest eine der äußeren Wandflächen des Formteils, vorzugsweise sämtliche Wandflächen bildet. Dadurch kann eine ausreichend hohe elektrische Leitfähigkeit auch an den Oberflächen des Formteils sichergestellt werden.

In dem Rahmen der Erfindung fällt auch eines Formteils nach Anspruch 11 , bei dessen Herstellung Reject-Material zerkleinert, insbesondere geschreddert oder granuliert, und durch Spritzgießen zum Formteil verarbeitet wird.

Vorteilhaft und technisch einfach realisierbar ist eine Variante des erfindungsgemäßen Verfahrens, bei der dem Reject-Material vor dem Spritzgießen ein Additiv zur Erhöhung der elektrischen Leitfähigkeit beigefügt wird.

Alternativ oder zusätzlich kann eine Verfahrensvariante eingesetzt werden, bei der dem Reject-Material vor dem Spritzgießen eine Haftvermittler- und/oder Farbstoff-Zugabe beigemischt wird, um die oben beschriebenen Materialeigenschaften zu erreichen und die entsprechenden Vorteile zu erzielen.

Schließlich fällt in den Rahmen der vorliegenden Anmeldung auch die Verwendung von recyceltem Reject-Material zur Herstellung eines elektrisch leitfähigen und elektromagnetische Strahlen abschirmenden Formteils der erfindungsgemäßen Art mittels eines der oben beschriebenen Verfahren.

Weitere Merkmale und Vorteile der Erfindung ergeben sich aus den Unteransprüchen.

## Patentansprüche

1. Verfahren zur Herstellung eines Kunststoff-Formteils, insbesondere eines Behälters, mit Abschirmwirkung gegen elektromagnetische Strahlung,
**dadurch gekennzeichnet,**
**dass** für die Herstellung des Formteils mindestens zur Hälfte recyceltes Reject-Material bestehend aus Polyäthylen mit einem GewichtsAnteil von mindestens 10% Aluminium verwendet wird,
**dass** das Reject-Material zerkieinert und durch Spritzgießen zum Formteil verarbeitet wird,
und **dass** dem Reject-Material vor dem Spritzgießen ein Additiv zur Erhöhung der elektrischen Leitfähigkeit beigefügt wird, so
**dass** das Formteil nach der Herstellung einen elektrischen Oberflächen-Widerstand R < 10⁸Ω aufweist.

2. Verfahren nach Anspruch 1, **dadurch gekennzeichnet, dass** dem Reject-Material vor dem Spritzgießen eine Haftvermittler- und/oder Farbstoff-Zugabe beigemischt wird.

3. Verfahren nach Anspruch 1 oder 2, **dadurch gekennzeichnet, dass** der Aluminium-Anteil im Reject-Material ca. 15 bis 20 Gew% beträgt.

4. Verfahren nach einem der vorhergehenden Ansprüche, **dadurch gekennzeichnet, dass** das recycelte Reject-Material vor der Herstellung des Formteils durch Spritzgießen geschreddert und granuliert wird.

5. Verfahren nach einem der vorhergehenden Ansprüche, **dadurch gekennzeichnet, dass** das Formteil vollständig aus recyceltem Reject-Material hergestellt wird.

6. Verfahren nach einem der vorhergehenden Ansprüche, **dadurch gekennzeichnet, dass** das formteil aus recyceltem Reject-Material mit einem oder mehreren Additiven von fein verteiltem Material mit einer höheren elektrischen Leitfähigkeit als der des Reject-Materials, hergestellt wird.

7. Verfahren nach Anspruch 6, **dadurch gekennzeichnet, dass** die Menge und/oder die elektrischen Eigenschaften des Additivs so gewählt werden, dass das Formteil einen elektrischen Oberflächen-Widerstand R zwischen 10²Ω und 10⁸Ω, vorzugsweise zwischen 10⁴Ω und 10⁷Ω aufweist.

8. Verfahren nach einem der Ansprüche 6 oder 7, **dadurch gekennzeichnet, dass** das Additiv Metallpartikel umfasst.

9. Verfahren nach einem der Ansprüche 6 bis 8, **dadurch gekennzeichnet, dass** das Additiv recyceltes Abfall-Material enthält, insbesondere Kunststoffmaterial mit metallhaltigen Partikeln.

10. Verfahren nach Anspruch 9, **dadurch gekennzeichnet, dass** das Additiv längliche und/oder flächige Schnitzel, Streifen oder Fäden aus Metallfolie, insbesondere Aluminiumfolie enthält.

11. Formteil, hergestellt durch ein Verfahren nach einem der Ansprüche 1 bis 10, **dadurch gekennzeichnet, dass** das Formteil kastenförmig, insbesondere ein Behälter zur Aufbewahrung von Elektronikbauteilen, ist.

12. Formteilhergestellt durch ein Verfahren nach einem der Ansprüche 1 bis 10, **dadurch gekennzeichnet, dass** das Formteil röhrenförmig, rinnenförmig oder trogförmig ist.

13. Formteil, hergestellt durch ein Verfahren nach einem der Ansprüche 1 bis 10, **dadurch gekennzeichnet, dass** das Formteil ein Element der Innenarchitektur, insbesondere ein Deckenverkleidungs-, Wandverkleidungs- oder Bodenbedeckungs-Element ist.

## Claims

1. Method for producing a plastic moulding, in particular a container with shielding properties against electromagnetic radiation, **characterized in that** at least half of the material used for producing the moulding is recycled reject material consisting of polyethylene that contains at least 10% by weight of aluminium; **in that** the reject material is broken up and processed into the moulding by injection moulding; and **in that** an additive is admixed with the reject material prior to injection moulding in order to increase electrical conductivity, so that, after production, the moulding has an electrical surface resistance of R < 10⁸Ω.

2. Method according to Claim 1, **characterized in that** the reject material is admixed with a bonding agent and/or colourant prior to injection moulding.

3. Method according to Claim 1 or 2, **characterized in that** the proportion of aluminium in the reject material amounts to approximately 15 to 20% in weight.

4. Method according to one of the preceding claims, **characterized in that** the recycled reject material, prior to the production of the moulding by injection moulding, is shredded and granulated.

5. Method according to one of the preceding claims, **characterized in that** the moulding is produced entirely from recycled reject material.

6. Method according to one of the preceding claims, **characterized in that** the moulding made from recycled reject material is produced with one or several additives, forming a finely dispersed material with a higher electrical conductivity than the reject material.

7. Method according to Claim 6, **characterized in that** the quantity and/or the electrical properties of the additive are selected so that the moulding has an electrical surface resistance R of between 10²Ω and 10⁸ Ω, preferably between 10⁴Ω and 10⁷Ω.

8. Method according to one of Claims 6 or 7, **characterized in that** the additive contains metal particles.

9. Method according to one of Claims 6 to 8, **characterized in that** the additive contains recycled waste material, in particular plastic material with metal-containing particles.

10. Method according to Claim 9, **characterized in that** the additive contains long and/or flat shreds, strips or threads of metal foil, in particular aluminium foil.

11. Moulding, produced using a method according to one of Claims 1 to 10, **characterized in that** the moulding is box-shaped, in particular for the storage of electronic components.

12. Moulding, produced using a method according to one of Claims 1 to 10, **characterized in that** the moulding is tubular, gutter-shaped or trough-shaped.

13. Moulding, produced using a method according to one of Claims 1 to 10, **characterized in that** the moulding is an element of interior design, in particular an element for covering ceilings, walls and floors.

## Revendications

1. Procédé de fabrication d'une pièce moulée en matériau plastique, en particulier d'un récipient, ayant un effet de blindage contre le rayonnement électromagnétique, **caractérisé en ce que**, pour la fabrication de la pièce moulée, du matériau recyclé rejeté constitué de polyéthylène avec un pourcentage en poids d'au moins 10 % d'aluminium est utilisé au moins pour moitié, **en ce que** le matériau rejeté est concassé et transformé en pièce moulée par moulage par injection, et **en ce qu'**un additif est ajouté au matériau rejeté avant le moulage par injection pour augmenter l'électroconductibilité, de sorte que la pièce moulée présente après la fabrication une résistance électrique de surface R < 10⁸Ω.

2. Procédé selon la revendication 1, **caractérisé en ce qu'**une addition d'agent d'accrochage et/ou de colorant est ajoutée au matériau rejeté avant le moulage par injection.

3. Procédé selon la revendication 1 ou 2, **caractérisé en ce que** le pourcentage d'aluminium dans le matériau rejeté est d'environ 15 à 20 % en poids.

4. Procédé selon l'une des revendications précédentes, **caractérisé en ce que** le matériau recyclé rejeté est déchiqueté et granulé avant la fabrication de la pièce moulée par moulage par injection.

5. Procédé selon l'une des revendications précédentes, **caractérisé en ce que** la pièce moulée est fabriquée entièrement en matériau recyclé rejeté.

6. Procédé selon l'une des revendications précédentes, **caractérisé en ce que** la pièce moulée en matériau recyclé rejeté est fabriquée avec un ou plusieurs additifs de matériau finement distribué avec une électroconductibilité supérieure à celle du matériau rejeté.

7. Procédé selon la revendication 6, **caractérisé en ce que** la quantité et/ou les caractéristiques électriques de l'additif sont sélectionnées de telle sorte que la pièce moulée présente une résistance électrique de surface R située entre 10²Ω et 10⁸Ω, de préférence entre 10⁴Ω et 10⁷Ω.

8. Procédé selon l'une des revendications 6 ou 7, **caractérisé en ce que** l'additif comprend des particules métalliques.

9. Procédé selon l'une des revendications 6 à 8, **caractérisé en ce que** l'additif contient du matériau de rebut recyclé, en particulier du matériau plastique avec des particules métallifères.

10. Procédé selon la revendication 9, **caractérisé en ce que** l'additif contient des copeaux, des bandes ou des fils allongés et/ou plans de feuille métallique, en particulier de feuille d'aluminium.

11. Pièce moulée, fabriquée par un procédé selon l'une des revendications 1 à 10, **caractérisée en ce que** la pièce moulée est en forme de caisse, en particulier un récipient pour le dépôt de composants électroniques.

12. Pièce moulée, fabriquée par un procédé selon l'une des revendications 1 à 10, **caractérisée en ce que** la pièce moulée est tubulaire, en forme de gouttière ou en forme d'auge.

13. Pièce moulée, fabriquée par un procédé selon l'une des revendications 1 à 10, **caractérisée en ce que** la pièce moulée est un élément d'architecture intérieure, en particulier un élément de revêtement du plafond, de revêtement mural ou de recouvrement du sol.
